Europäisches Patentamt

European Patent Office

Office européen des brevets

(11) Publication number: **0 067 705**
**B1**

(12) **EUROPEAN PATENT SPECIFICATION**

(45) Date of publication of patent specification: **07.05.86**

(51) Int. Cl.⁴: **H 01 L 21/68**

(21) Application number: **82303082.0**

(22) Date of filing: **15.06.82**

(54) **Wafer transport system.**

(30) Priority: **15.06.81 JP 90952/81**

(43) Date of publication of application:
**22.12.82 Bulletin 82/51**

(45) Publication of the grant of the patent:
**07.05.86 Bulletin 86/19**

(84) Designated Contracting States:
**DE GB NL**

(56) References cited:
**FR-A-2 403 866**

(73) Proprietor: **Hitachi, Ltd.**
**5-1, Marunouchi 1-chome**
**Chiyoda-ku Tokyo 100 (JP)**

(72) Inventor: **Yagi, Kunihiro**
**2196-217 Hirai Hinodemachi**
**Nishitama-gun Tokyo (JP)**
Inventor: **Usui, Hiroo**
**3299 Tokiwa-cho**
**Machida-shi Tokyo (JP)**
Inventor: **Suzuki, Michio**
**971-118 Mogusa**
**Hino-shi Tokyo (JP)**
Inventor: **Hashimoto, Norikazu**
**168-90 Shimo-yugi**
**Hachioji-shi Tokyo (JP)**
Inventor: **Matuoka, Sadao**
**462 Chigira Sagamiko-machi**
**Tsukui-gun Kanagawa-ken (JP)**

(74) Representative: **Paget, Hugh Charles Edward**
**et al**
**MEWBURN ELLIS & CO. 2/3 Cursitor Street**
**London EC4A 1BQ (GB)**

Courier Press, Leamington Spa, England.

## Description

The present invention relates to a transport system for semiconductor wafers in manufacturing processes for semiconductor devices.

Various semiconductor devices and integrated circuits (ICs, LSIs) are manufactured using Si wafers. However, sufficient regard has not been paid to the foreign particles which adhere to the Si wafers in the semiconductor manufacture processes, and suitable countermeasures have not been taken in the apparatus used in such processes.

An object of the present invention is to reduce the number of foreign particles which adhere to a wafer when the wafer is introduced into a vacuum evacuation chamber, or of foreign particles which exist in the evacuation chamber and which are scattered so as to adhere to the wafer when a gas is introduced as a leak into the vacuum.

The invention provides an evacuation aperture near the wafer introduction or delivery port of a vacuum lock chamber, so that gas in the port can be removed by suction.

An embodiment of the invention will now be described by way of example with reference to the accompanying drawings in which:—

Figure 1 is a schematic diagram of a prior-art wafer transport system in an ion implanter;

Figure 2 is a sectional view showing the structure of a vacuum lock chamber and a wafer cassette in the system of Figure 1 and also illustrates an optional feature of the present invention;

Figure 3 is a schematic diagram of an embodiment of the present invention;

Figures 4(A) and 4(B) are sectional views showing the structure of an evacuation hole region in Figure 3; and

Figures 5 and 5 are graphs showing the effects obtainable with the present invention.

As semiconductor devices have become finer in size and of higher packaging density, the reduction of foreign particles adhering to them has become high-lighted as an important problem.

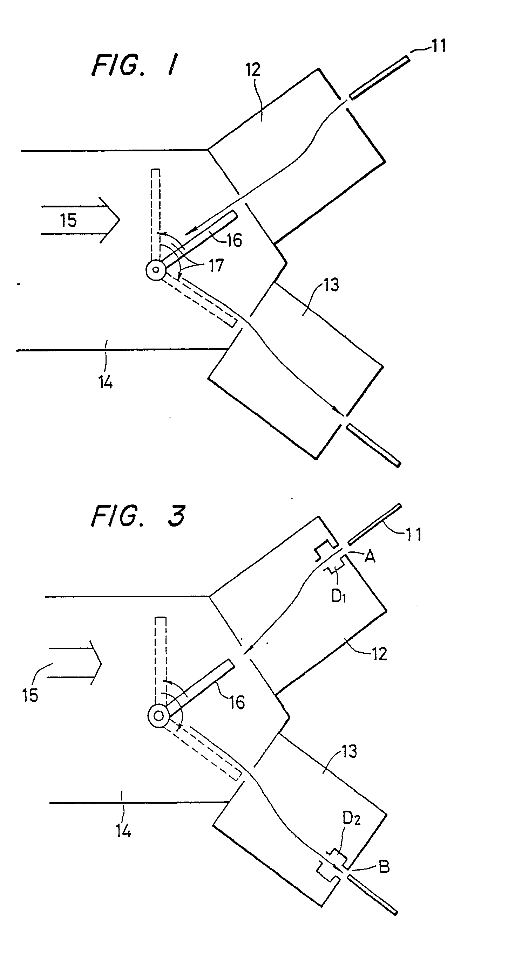

The present invention will be described using an ion implantation process as an example, but is applicable in other processes. An ion implantation system of this example is a medium current ion implanter, Model 200—CF4 manufactured by Varian/Extrion Inc. A schematic view of a mechanism and system for introducing wafers into and drawing them out of a chamber (implant chamber) where the ion implantation is performed within the ion implantation system, is shown in Figure 1, which shows the Si wafer 11, vacuum lock chambers 12, 13, the implant chamber 14, an ion beam 15, a wafer platen 16, and by arrow 17 the range of movement of the platen.

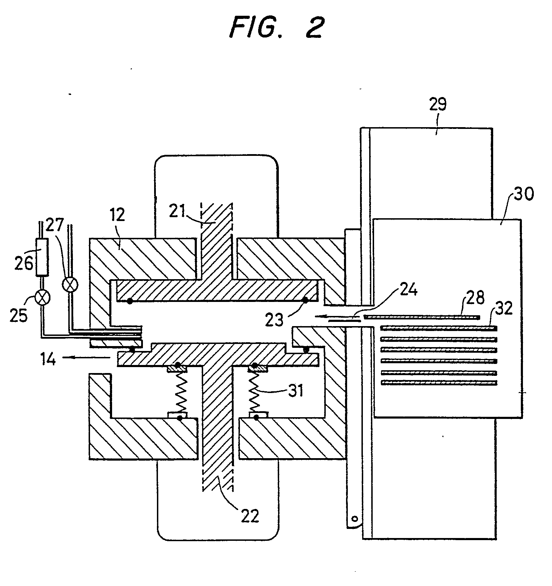

The details of the wafer transport mechanism shown in Figure 1 will be described with reference to Figure 2. A Si wafer 28 received in a wafer cassette 30 slides onto a wafer introducing slide plate 24 by gravity (because the chamber 12 as seen in Figure 1 is on a slant), and arrives on a lower valve (wafer stage) 22 in the vacuum lock chamber 12. Then, an upper valve 21 descends to vacuum seal the space containing the wafer by an O-ring 23. A magnet valve 27 is opened, and this small space between the upper valve 21 and the lower valve 22 (with the Si wafer lying thereon) is evacuated to vacuum. When at least a predetermined degree of vacuum has been reached, the lower valve 22 descends, and the Si wafer is introduced into the implant chamber 14 which is held under vacuum.

During the ion implantation processing of this wafer, the next wafer 32 is transported into the vacuum lock chamber. This operation is carried out as follows. After the preceding Si wafer 28 has been introduced into the implant chamber 14, the lower valve 22 ascends, and $N_2$ is leaked into the small space between the upper valve 21 and the lower valve 22 to bring it into atmospheric pressure by opening the solenoid valve 27. After atmospheric pressure has been reached, the upper valve 21 ascends. Then the cassette shifting mechanism 29 lifts the cassette 30 so that the next Si wafer 32 in the cassette 30 comes to the position 28. Subsequent operations are the same as when transporting the first Si wafer 28.

The wafer transport system described above has an excellently high through-put rate of the wafers, and a rate of up to 250 wafers/hour may be attained, though the through-put depends also upon the ion dose. This system, however, is disadvantageous in the appearance of dust because the Si wafers themselves slide on the metal surfaces one by one and the evacuation and the leakage operations are repeated.

More specifically, the wafer is often coated with photoresist as a mask, and it is also common that foreign particles adhere on the wafer. Such foreign particles fall off due to the sliding of the wafer on the metal surfaces, and accumulate in the implant chamber. In addition, dust particles are blown around during the evacuation and the leakage operations, resulting in their adherence on the wafer. After the ion implantation, the wafers were observed with a metallurgical microscope, and it has been found that the foreign particles on the wafer consist chiefly of photoresist flakes and silicon fragments.

When semiconductor devices are in the future rendered still finer in size and of higher packaging density, it is conjectured that the foreign particles will form a major cause of defects because they might act for example, as a mask in the ion implantation step.

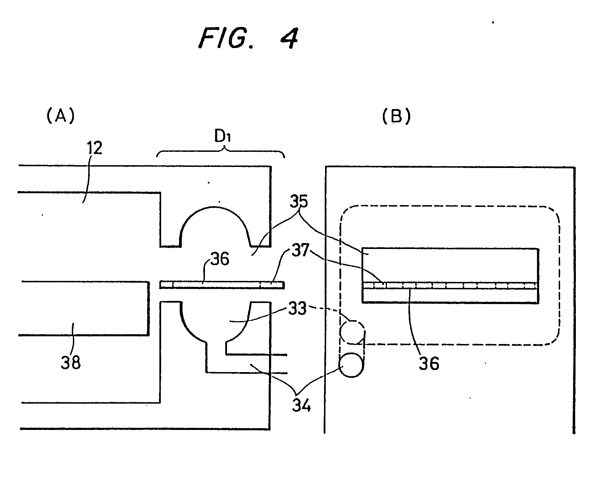

An embodiment of the present invention, in which evacuation compartments are provided at the wafer entrance and exit points, is illustrated in Figures 3, 4(A) and 4(B). The evacuation compartments $D_1$ and $D_2$ are formed at the wafer entrance port A and wafer exit port B respectively of the vacuum lock chambers 12 and 13 as shown in Figure 3, and details of the evacuation compartment $D_1$ are illustrated in Figures 4(A) and 4(B). Figure 4(B) is a diagram of the evacuation compartment as viewed looking at the opening 35 in Figure 4(A).

A Si wafer is fed into the vacuum lock chamber 12 by passing through the entrance opening 35 and sliding on a slide plate 37, and arrives on a stage 38 within the chamber 12. In the present embodiment, an evacuation hole 33 is formed in the entrance opening 35, whereby the air in the entrance opening 35 can be evacuated through an evacuation port 34. In addition, the slide plate 37 has a perforated plate structure 36, so that dust falling off when the wafer slides and passes by is drawn through the perforated plate structure 36 and from the evacuation hole 33 by suction. The use of the evacuation aperture 33 according to the present invention has the effect of reducing the number of foreign particles present because (a) dust particles which are blown around when $N_2$-gas which has been leaked into the vacuum lock chamber 12 to bring it up to the atmospheric pressure, flows out into the entrance opening 35, (b) dust particles which fall off when the Si wafer passes, and (c) foreign particles which lie on the wafer are all drawn away through the evacuation hole 33 by suction.

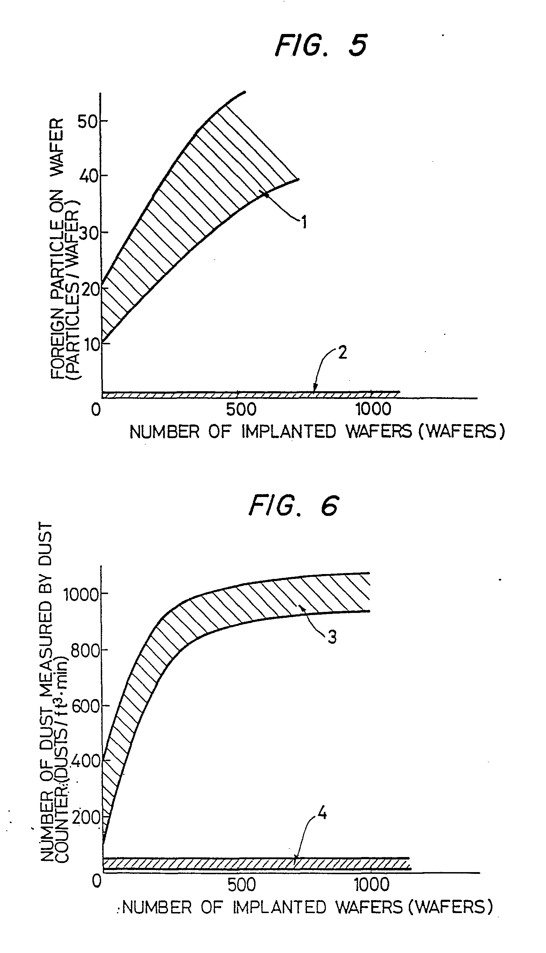

This effect in one case will now be described in detail. Figure 5 illustrates results obtained when, after Si wafers had been subjected to ion implantation by passing them through the zones $12 \rightarrow 14 \rightarrow 13$ (Figs. 1 and 3) foreign particles of size 0.5 μm and larger adhering on the Si wafers of 3 inches size (7.5 cm) were measured by a wafer-surface defect detector utilizing laser beam scattering. In the case where the present invention was not applied, the number of the foreign particles measured was about 10—20 particles/wafer immediately after the vacuum lock chambers 12 and 13 had been scavenged. However, when a large number of wafers were subjected to the ion implantation process, the number of the foreign particles increased and was as many as 50 particles/wafer after about 500 implanted wafers. These quantities of foreign particles are indicated as a region 1 in Figure 5. In addition, Figure 6 illustrates results obtained when the gas flowing out in the vicinity of the wafer entrance port $D_1$ was sampled by a dust counter to measure the number of dust particles of size 0.5 μm and larger. The number of the dust particles increased with increase in the number of implanted wafers as in the measurements of Fig. 5, and whereas there were 100—400 particles/ft³.min immediately after the scavenging of the vacuum lock chambers, it increase to about 1000 particles/ft³.min after the implantation of 500 wafers. These quantities of dust particles are indicated by region 3 in Figure 6. On the other hand, where the system of the present invention was adopted, the number of foreign particles on the Si wafer after the ion implantation process decreased to 0—2 particles/wafer as indicated by region 2 in Figure 5, and this level was maintained even after about 1000 wafers had been implanted. This effect was also confirmed by the fact that the number of dust particles in the vicinity of the wafer entrance was suppressed to below 50 particles/ft³.min as indicated by region 4 in Figure 6. Thus, it is apparent that, in the present invention, the number of foreign particles carried into the vacuum lock chamber 12 while adhering on the Si wafer decreases in itself and that foreign particles accumulated in the vacuum lock chambers are drawn through the evacuation hole 33 by suction during the $N_2$-gas purge.

The second improvement obtainable with the present invention, illustrated by Figure 2, will now be described. In the prior art system, the evacuation magnet valve and the $N_2$ leakage magnet valve are the same (as at 27 in Figure 2), so that dust particles withdrawn in the vacuum evacuation are conversely spouted back during the $N_2$ leakage to scatter and adhere onto the Si wafer on the lower-stage valve 22. (Since the $N_2$ is leaked until the upper valve 21 starts descending after the Si wafer has arrived on the lower valve 22, it continues to flow out toward the wafer cassette 30.) In the preferred embodiment of the present invention this disadvantage is avoided in that, as illustrated in Figure 2, a magnet valve 25 for leaking $N_2$ is separate from the magnet valve 27 for the evacuation. A filter 26 is added to $N_2$-leakage pipe so as to remove dust in the $N_2$ gas.

The present invention is not only applicable to an ion implanter but can be utilized in all cases of introduction of Si or other wafers into a vacuum evacuation chamber. The invention can be similarly utilized where a silicon wafer is transported while located on a support plate. In brief, the invention is effective in apparatuses in which dust during the transport of wafers poses a problem, and has wide applications.

**Claims**

1. A wafer transport system wherein a wafer is introduced into a vacuum lock chamber (12) and/or delivered from a vacuum lock chamber (13) via respectively a wafer introduction port (35) or a wafer delivery port, there being an evacuation port for the or each vacuum lock chamber connectible to evacuation means, characterised in that
there is provided a further evacuation aperture (33) at or adjacent to said introduction port and/or delivery port whereby gas in the introduction and/or delivery port can be removed by suction.

2. A wafer transport system according to claim 1 having a slide plate (37) on which the wafer slides near said introduction or delivery port.

3. A wafer transport system according to claim 2, wherein said further evacuation apertures (33) extends around said wafer slide plate (37) which is disposed in said wafer introduction port or delivery port.

4. A wafer transport system according to claim 2 or claim 3, wherein said wafer slide plate (37) has a perforated structure.

5. A wafer transport system according to any one of claims to 4 wherein separate pipe lines are respectively used for vacuum evacuation from said chamber (12, 13) and admission of gas into said chamber (12, 13).

## Revendications

1. Système de transport pour plaquette où une plaquette est introduite dans un sas sous vide (12) et/ou extraite d'un sas (13) sous vide, respectivement, par un orifice (35) d'introduction de la plaquettte ou un orifice de sortie de la plaquette, avec un orifice d'évacuation pour le ou chaque sas sous vide pouvant être relié à un moyen d'évacuation,
caractérisé en ce que
on prévoit une autre ouverture d'évacuation (33) sur ou près dudit orifice d'introduction et/ou dudit orifice de sortie, ainsi le gaz dans l'orifice d'introduction et/ou de sortie peut être retiré par aspiration.

2. Système de transport pour plaquette selon la revendication 1 ayant une plaque coulissante (37) sur laquelle la plaquette glisse à proximité dudit orifice d'introduction ou de sortie.

3. Système de transport pour plaquette selon la revendication 2, où ladite autre ouverture d'évacuation (33) s'étend autour de ladite plaque coulissante (37) de la plaquette qui est disposée dans ledit orifice d'introduction de la plaquette ou ledit orifice de sortie.

4. Système de transport pour plaquette selon la revendication 2 ou la revendication 3, où ladite plaque coulissante (37) de la plaquette a une structure perforée.

5. Système de transport pour plaquette selon l'une quelconque des revendications 1 à 4, où des lignes séparées sont respectivement utilisées pour l'évacuation de ladite chambre (10, 13) et l'admission du gaz dans ladite chambre (12, 13).

## Patentansprüche

1. Wafer-Transportsystem, wobei ein Wafer über eine Wafer-Einführungsöffnung (35) bzw. eine Wafer-Abgabeöffnung in eine Vakuum-Schleusenkammer (12) eingeführt und/oder von einer Vakuum-Schleusenkammer (13) abgeführt wird, mit einer Evakuierungsöffnung für die oder jede Vakuum-Schleusenkammer, die mit einer Evakuierungseinrichtung zu verbinden ist,
dadurch gekennzeichnet,
daß eine weitere Evakuierungsöffnung (33) an oder in der Nähe der genannten Einführungsöffnung und/oder der Abgabeöffnung vorgesehen ist, womit Gas in der Einführungs- und/oder Abgabeöffnung durch Absaugen entfernt werden kann.

2. Wafer-Transportsystem nach Anspruch 1, das eine Gleitplatte (37) hat, auf der der Wafer in die Nähe der Einführungs- oder Abgabeöffnung gleitet.

3. Wafer-Transportsystem nach Anspruch 2, wobei die weitere Evakuierungsöffnung (33) um die Wafer-Gleitplatte (37) herum verläuft, die in der Wafer-Einführungsöffnung oder -Abgabeöffnung angeordnet ist.

4. Wafer-Transportsystem nach Anspruch 2 oder Anspruch 3, wobei die Wafer-Gleitplatte (37) eine perforierte Struktur hat.

5. Wafer-Transportsystem nach einem der Ansprüche 1 bis 4, wobei für die Evakuierungs-Absaugung aus der Kammer (12, 13) und für die Zuführung von Gas in die Kammer (12, 13) jeweils getrennte Röhrenleitungen verwendet werden.

*FIG. 1*

*FIG. 3*

## FIG. 2

FIG. 4

(A)

(B)

$D_1$

12

35

36

37

33

38

34

36

0 067 705

## FIG. 5

Y-axis: FOREIGN PARTICLE ON WAFER (PARTICLES / WAFER)
X-axis: NUMBER OF IMPLANTED WAFERS (WAFERS)

## FIG. 6

Y-axis: NUMBER OF DUST MEASURED BY DUST COUNTER (DUSTS / ft$^3$·min)
X-axis: NUMBER OF IMPLANTED WAFERS (WAFERS)